# EUROPEAN PATENT SPECIFICATION

(11) **EP 1 946 133 B1**
(45) Date of publication and mention of the grant of the patent: **19.12.2012**
(21) Application number: 06787834.8
(22) Date of filing: 19.07.2006
(51) Int. Cl.: G01R 31/36

(54) **Battery analysis system for determining quantity of cells of a battery**
Batterieanalysesystem zur Bestimmung der Zellenzahl einer Batterie
Système d'analyse d'une batterie pour déterminer la quantité de cellules d'une batterie

(30) Priority: 27.10.2005 US 261294
(43) Date of publication of application: 23.07.2008
(73) Proprietor: HEWLETT-PACKARD DEVELOPMENT COMPANY, L.P., Houston TX 77070 (US)
(72) Inventor: WOZNIAK, John, Houston, TX 77070 (US)
(74) Representative: Schoppe, Fritz
(86) International application number: PCT/US2006/028003
(87) International publication number: WO 2007/050155

(56) References cited:
- EP-A- 0 743 533
- WO-A-97/13189
- WO-A1-00/39907
- GB-A- 2 314 936
- US-A- 5 432 429
- US-A- 5 565 759

## Description

### BACKGROUND OF THE INVENTION

Notebook or laptop computers and other types of portable computing devices utilize an internal battery to enable self-powered use of the computing device (i.e., independent of an electrical outlet and/or other type of external power source). When a consumer and/or user of the computing device perceives a problem associated with the battery, a replacement battery is either purchased by the user or a warranty replacement battery is sought (e.g., if the battery is still under warranty). However, working batteries are many times unnecessarily replaced as the battery is either functioning properly or simply requires re-calibration, thereby resulting in the consumer and/or the battery vendor incurring additional and unnecessary costs.

EP 0 743 533 A2 describes an electronic device that monitors a battery having a memory for an error condition while the battery is operating the device. If the battery support unit finds an error condition with the battery, it transmits error data to a mailbox located in the battery's memory. Other electronic devices or battery support units, or even this electronic device at a later date, can read the error data in the mailbox and take an appropriate action.

WO 97/13189 A describes a microcontroller for use in battery charging and monitoring applications. The microcontroller includes a microprocessor and various front-end analog circuitry including a slope A/D converter and a multiplexer for allowing a plurality of analog input signals to be converted to corresponding digital counts indicative of signal level.

US 5,432,429 A describes a battery monitoring/control device that includes a monitor/control device that is operable to be integrated with a microprocessor system. The system includes a CPU that interfaces with a data bus and an address bus. The control/monitor device includes a controller/data register block and a battery charge control/monitor block. The device is operable to monitor the battery voltage of a secondary battery during charging thereof and to control the rate of charge through a transistor.

WO 00/39907 A1 describes systems comprised of hardware assemblies, either embedded or external, which use software for processes such as acquiring power-related values, principally by the use of a connector that accesses a battery, in order for a processor to calculate an optimized power signal, and then to configure an output of a power supply to deliver the power signal to a powered device. Alternatively, the power-related values are transmitted form the battery in case of a smart battery.

### SUMMARY OF THE INVENTION

It is an object of the invention to provide an improved battery analysis system.

This object is achieved by a system according to claim 1.

### BRIEF DESCRIPTION OF THE DRAWINGS

For a more complete understanding of the present invention and the advantages thereof, reference is now made to the following descriptions taken in connection with the accompanying drawings in which:

FIGURE 1 is a diagram illustrating an embodiment of a battery analysis system in accordance with the present invention;

FIGURE 2 is a flow diagram illustrating an embodiment of a battery analysis method in accordance with the present invention;

FIGURE 3 is a flow diagram illustrating another embodiment of a battery analysis method in accordance with the present invention;

FIGURE 4 is a flow diagram illustrating another embodiment of a battery analysis method in accordance with the present invention;

FIGURE 5 is a flow diagram illustrating another embodiment of a battery analysis method in accordance with the present invention; and

FIGURE 6 is a flow diagram illustrating yet another embodiment of a battery analysis method in accordance with the present invention.

### DETAILED DESCRIPTION OF THE DRAWINGS

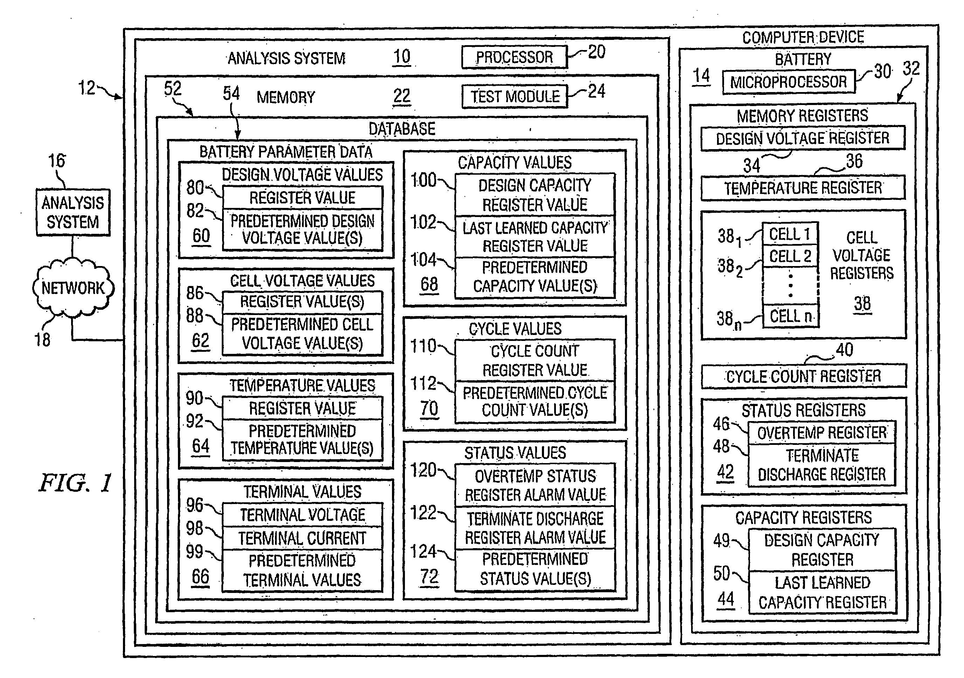

The preferred embodiments of the present invention and the advantages thereof are best understood by referring to FIGURES 1-6 of the drawings, like numerals being used for like and corresponding parts of the various drawings.

FIGURE 1 is a diagram illustrating an embodiment of a battery analysis system 10 in accordance with the present invention. In the embodiment illustrated in FIGURE 1, analysis system 10 is illustrated as being disposed within a computer device 12 for analyzing and/or otherwise determining whether a battery 14 is defective and/or otherwise needs replacement. Computer device 12 may comprise any type of computer device such as, but not limited to, a laptop or notebook computer, tablet computer, personal digital assistant, or any other type of computer device capable of being battery powered. In the embodiment illustrated in FIGURE 1, battery 14 is illustrated as being part and/or otherwise forming a part of computer device 12 (e.g., an internal battery 14). However, it should be understood that battery 14 may comprise an external battery (e.g., a travel battery, secondary battery, or other type of external battery). In the embodiment illustrated in FIGURE 1, analysis system 10 is illustrated as being disposed within and/or otherwise forming a part of computer device 12. However, it should be understood that analysis system 10 may be otherwise located relative to computer device 12. For example, in the embodiment illustrated in FIGURE 1, analysis system 10 may be located remote from computer device 12, illustrated generally by 16, and configured to communicate and/or otherwise interface with battery 14 via a communication network 18 (e.g., the internet, an Intranet, a local area network (LAN), a wide area network (WAN), or other type or wired and/or wireless communications network). For ease of description, only analysis system 10 is described below; however, it should be understood that system 16 may be similarly configured for remote use thereof. Further, it should be understood that embodiments of the present invention are not limited to having a single system 10 or 16 (e.g., computer device 12 may be configured having an internal system 10 and also be configured to enable remote access thereto by system 16).

In the embodiment illustrated in FIGURE 1, analysis system 10 comprises a processor 20 and a memory 22. Processor 20 may be a discrete processor element forming a part of analysis system 10 and/or analysis system 10 may utilize another processing element disposed on computer device 12. In the illustrated embodiment, analysis system 10 comprises a test module 24. Test module 24 may comprise hardware, software, or a combination of hardware and software. In the embodiment illustrated in FIGURE 1, test module 24 is illustrated as being stored in memory 22 so as to be accessible and executable by processor 20. However, it should be understood that test module 24 may be otherwise located, even remotely from computer device 12. In operation, test module 24 accesses various information from battery 14 and analyzes such information to determine whether battery 14 is defective and/or otherwise needs replacement. Preferably, computer device 12 is operating using a power source other than the analyzed battery 14 (e.g., external alternating current (AC) outlet or AC adapter) when running analysis system 10 to facilitate accurate readings from battery 14. It should be understood that a determination that battery 14 is defective and/or otherwise needs replacement may be based on results of an analysis performed after a re-calibration of battery 14 and/or before a re-calibration of battery 14.

In the embodiment illustrated in FIGURE 1, battery 14 comprises a microprocessor 30 and one or more memory registers 32. Memory registers 32 comprise information stored by microprocessor 30 associated with various preset and/or operating parameters of battery 14. For example, information stored in registers 32 may comprise information preset and/or stored in battery 14 prior to a first customer use of battery 14 (e.g., default values, design values and/or other types of information stored in registers 32 prior to battery 14 leaving a factory) and/or information monitored, logged, and/or otherwise stored by microprocessor 30 during operation of battery 14 (e.g., during the use of battery 14 by with computer device 12).

In the embodiment illustrated in FIGURE 1, memory registers 32 comprise a design voltage registe̊r 34, a temperature register 36, cell voltage register(s) 38, a cycle count register 40, status register(s) 42 and capacity register(s) 44. As discussed above, information stored in memory registers 32 may comprise information acquired and/or otherwise collected during use of battery 14 and/or information pre-stored before in battery 14. For example, in some embodiments of the present invention, design voltage register 34 comprises information associated with a designed voltage level of battery 14, temperature register 36 comprises information associated with recorded operating temperatures of battery 14 (e.g., a minimum and/or maximum recorded operating temperature), cell voltage register(s) 38 comprise cell voltage levels for each cell 38₁-38ₙ of battery 14, cycle count register 40 comprises information associated with a quantity of recharged cycles of battery 14, status register(s) 42 comprise information associated with various status alarm bits or indicators, and capacity register(s) 44 comprise information associated with charge capacities of battery 14. For example, in the embodiment illustrated in FIGURE 1, status register(s) 42 comprise an overtemp register 46 having information associated with an over-temperature condition of battery 14, and a terminate discharge register 48 having information associated with discharging of battery 14. Additionally, in the embodiment illustrated in FIGURE 1, capacity register(s) 44 comprise a design capacity register 49 having information associated with designed charge capacity of battery 14, and a last-learned capacity register 50 having information associated with a last-determined and/or stored charge capacity level of battery 14. However, it should be understood that battery 14 may comprise other types of memory registers 32 and/or related information usable by analysis system 10 to determine whether battery 14 is defective.

In operation, test module 24 reads information from various memory registers 32 of battery 14 to determine whether battery 14 is defective and/or otherwise needs replacement. For example, in some embodiments of the present invention, test module 24 reads information from various memory registers 32 and compares the read values to predetermined thresholds and/or predetermined ranges of values. In the embodiment illustrated in FIGURE 1, a database 52 has battery parameter data 54. Battery parameter data 54 comprises information associated with values read from memory registers 32 and/or predetermined values used to analyze and/or evaluate the read register values to determine whether battery 14 is defective and/or otherwise needs replacement.

In the embodiment illustrated in FIGURE 1, battery parameter data 54 comprises design voltage values 60, cell voltage values 62, temperature values 64, terminal values 66, capacity values 68, cycle values 70 and status values 72. Design voltage values 60 comprises a register value 80 representing a design voltage value read from design voltage register 34, and predetermined design voltage value(s) 82 representing preset and/or default design voltage value(s) of battery 14 used to analyze and/or evaluate the read register value 80 and/or otherwise used in combination with other read register values and/or predetermined values to determine whether battery 14 is defective and/or otherwise needs replacement. In the embodiment illustrated in FIGURE 1, cell voltage values 62 comprise register value(s) 86 representing cell voltage value(s) read from register(s) 38₁-38ₙ for each cell of battery 14, and predetermined cell voltage value(s) 88 representing predetermined threshold and/or ranges of cell voltage values used to analyze and/or evaluate the read register value(s) 86 and/or otherwise used in combination with other read register values and/or predetermined values to determine whether battery 14 is defective and/or otherwise needs replacement.

In the embodiment illustrated in FIGURE 1, temperature values 64 comprise a register value 90 representing a temperature register value read from temperature register 36, and predetermined temperature values 92 representing predetermined threshold and/or ranges of temperature values used to analyze and/or evaluate the read register value 90 and/or otherwise used in combination with other read register values and/or predetermined values to determine whether battery 14 is defective and/or otherwise needs replacement. Terminal values 66 comprise information associated with a terminal voltage level 96 and a terminal current level 98 at a power supply terminal of battery 14. For example, terminal value 66 represent actual voltage and current values 96 and 98, respectively, measured at a power supply terminal of battery 14. Terminal values 66 also comprises predetermined terminal values 99 representing predetermined threshold and/or ranges of terminal voltage and/or current values used to analyze and/or evaluate the determined value(s) 96 and/or 98 and/or otherwise used in combination with other read register values and/or predetermined values to determine whether battery 14 is defective and/or otherwise needs replacement Capacity values 68 comprise a design capacity register value 100 representing a design capacity register value read from design capacity register 49, a last-learned capacity register value 102 representing a last-learned capacity value read from last-learned capacity register 50, and predetermined capacity values 104 representing predetermined threshold and/or ranges of values used to analyze and/or evaluate the read register values 100 and/or 102 and/or otherwise used in combination with other read register values and/or predetermined values to determine whether battery 14 is defective and/or otherwise needs replacement.

Cycle values 70 comprises a cycle count register value 110 representing a cycle count value read from cycle count register 40, and predetermined cycle count values 112 representing a predetermined threshold and/or range of values used to analyze and/or evaluate the read register value 110 and/or otherwise used in combination with other read register values and/or predetermined values to determine whether battery 14 is defective and/or otherwise needs replacement. Status values 72 comprise an overtemp status register alarm value 120 representing an alarm and/or bit value read from overtemp register 46, a terminate discharge register alarm value 122 representing an alarm and/or bit value read from terminate discharge register 48, and predetermined status values 124 used in combination with overtemp status register alarm value 120 and/or terminate discharge register alarm value 122 to determine whether battery 14 is defective and/or otherwise needs replacement.

In some embodiments of the present invention, test module 24 reads design voltage register 34 to obtain design voltage register value 80 and uses predetermined design voltage values 82 to automatically determine a quantity of cells in battery 14. For example, in some embodiments of the present invention, predetermined design voltage values 82 comprise a predetermined and/or preset range of values generally associated with batteries having different cell counts (e.g., a different value range for each of a three-cell battery, four-cell battery, etc., to determine a quantity of cells in battery 14). Thus, for example, in some embodiments of the present invention, for a three-cell battery 14, design voltage register value 80 should generally fall between 10,800 millivolts (mV) and 11,100 mV, and for a four-cell battery, design voltage register value 80 should fall between 14,400 mV and 14,800 mV. It should be understood that other predetermined ranges of design voltage values 82 may be provided and/or otherwise used. Thus, test module 24 is configured to automatically determine a quantity of cells of battery 14 based on which predetermined design voltage value 82 range the read design voltage register value 80 falls. Further, if the read design voltage register value 80 does not fall within any predetermined design voltage value 82 ranges, test module 24 identifies battery 14 as being defective (e.g., indicating a corrupt design voltage register 34 and/or other anomaly generally associated with a defective battery 14).

In some embodiments of the present invention, test module 24 reads cell voltage register(s) 38 to determine cell voltage values for each cell of battery 14. For example, in some embodiments of the present invention, test module 24 reads cell voltage registers 38 for each cell 38₁-38ₙ and stores the register values as cell voltage register value(s) 86. Test module 24 evaluates the read cell voltage register values 86 and determines a maximum spread and/or difference between maximum and minimum cell voltage register values 86 read from cell voltage register(s) 38 corresponding to cells 38₁-38ₙ. In some embodiments of the present invention, predetermined cell voltage values 88 comprise a maximum threshold capacity difference value between cells 38₁-38ₙ. For example, if the maximum spread and/or difference between a maximum cell voltage register value 86 and a minimum cell voltage register value 86 read from cell voltage registers 38 exceeds a predetermined cell voltage threshold value 88 (e.g., 50 mV), test module 24 identifies battery 14 as defective (e.g., indicating a faulty battery cell, corrupt register 38, and/or other anomaly generally associated with a defective battery condition).

In some embodiments of the present invention, test module 24 reads temperature register value 90 from temperature register 36 and evaluates temperature register value 90 against predetermined temperature values 92. For example, in some embodiments of the present invention, predetermined temperature values 92 comprise predetermined minimum and/or maximum threshold values. Thus, for example, if temperature register value 90 falls below a predetermined minimum threshold temperature value 92 and/or exceeds a predetermined maximum threshold temperature value 92, test module 24 identifies battery 14 as defective (e.g., as a result of a possible thermistor disconnection, corrupt register, and/or other anomaly generally associated with a defective battery condition). In some embodiments of the present invention, test module 24 reads overtemp status register alarm value 120 and terminate discharge register alarm value 122 from overtemp register 46 and terminate discharge register 48, respectively, to determine whether alarm bits have been set in overtemp register 46 and/or terminate discharge register 48, respectively. If the alarm bits of status registers 42 have been set and/or otherwise correspond to predetermined status values 124 representing an alarm set or error log condition in status registers 42, test module 24 identifies battery 14 as defective (e.g., resulting from an overtemp condition, corrupt register, and/or other anomaly generally associated with a defective battery condition).

In some embodiments of the present invention, test module 24 reads terminal voltage value 96 and/or terminal current value 98 representing actual voltage and current values located at a power supply terminal of battery 14, respectively, and evaluates terminal voltage value 96 and/or terminal current value 98 to predetermined terminal values 99 and/or other read register values and/or information. For example, in some embodiments of the present invention, based at least on a determination of a quantity of cells of battery 14 (e.g., based on design voltage register value 80 read from design voltage register 34), test module 24 evaluates the terminal voltage value 96 and terminal current value 98 to determine if battery 14 is defective. For example, if battery 14 comprises four cells and terminal voltage value 96 is less than a predetermined terminal voltage level value 99 for a four-cell battery 14 (e.g., 11 mV for a four-cell battery 14) but terminal current value 98 is greater than a predetermined terminal current level value 99 (e.g., 500 mA), test module 24 identifies battery 14 as defective (e.g., indicating that battery 14 is not charging properly and/or generally indicating another anomaly generally associated with a defective battery condition).

In some embodiments of the present invention, test module 24 evaluates design capacity register value 100 read from design capacity register 49 and last-learned capacity register value 102 read from last-learned capacity register 50 with at least predetermined capacity values 104 to determine a condition of battery 14. For example, in some embodiments of the present invention, predetermined capacity value 104 represents a predetermined value and/or threshold ratio of last-learned capacity register value 102 relative to design capacity register value 100. Thus, for example, if a ratio of last-learned capacity register value 102 relative to design capacity register value 100 is greater than a predetermined value and/or threshold ratio value 104 (e.g., 110 %), test module 24 identifies battery 14 as defective (.e.g., indicating a corrupt register, a problem reading last-learned capacity register values 102 and/or another anomaly generally associated with a defective battery condition).

In some embodiments of the present invention, test module 24 evaluates cycle count register value 110 read from cycle count register 40 with predetermined cycle count values 112 and/or other read register values and/ or information to evaluate a condition of battery 14. For example, in some embodiments of the present invention, test module 24 evaluates cycle count register value 110 in combination with design capacity register value 100 and last-learned capacity register value 102 to evaluate a condition of battery 14. For example, if last-learned capacity register value 102 is less than half of design capacity register value 100 and cycle count register value 110 is less than a predetermined quantity of cycles indicated by value 112 (e.g., less than 300 charging cycles having been performed), test module 24 identifies battery 14 as defective (e.g., indicating an extremely low battery 14 capacity, a corrupt register, and/or another anomaly generally associated with a defective battery condition).

Thus, embodiments of the present invention evaluate one or more parameter values associated with battery 14 to automatically determine whether battery 14 is defective and/or otherwise needs replacement It should be understood that in some embodiments of the present invention, test module 24 is configured to indicate a defective battery 14 based on a single analyzed item and/or a combination of analyzed items (e.g., using multiple analyzed items as a check or verification against other analyzed items). Further, in some embodiments of the present invention, test module is configured to display an indication of battery 14 defective status (e.g., display element or flashing light emitting diode (LED)). Test module 24 may be configured to initiate analysis of battery 14 automatically (e.g., corresponding to a predetermined schedule, upon each boot of computer device 12 using power supplied by battery 14 and/or each time power to computer device 12 is switched from an external source to battery 14, or vice versa) or in response to a user request.

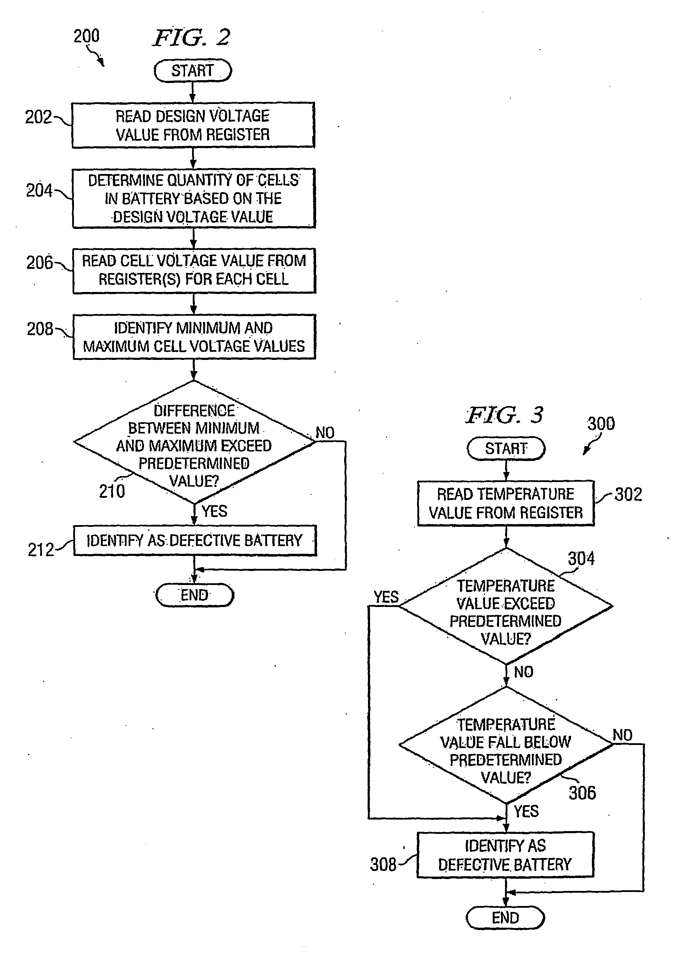

FIGURE 2 is a flow diagram illustrating an embodiment of a battery analysis method 200 in accordance with the present invention. The method begins at block 202, where test module 24 reads design voltage register value 80 from design voltage register 34. At block 204, test module 24 determines a quantity of cells in battery 14 based on design voltage register value 80. For example, as discussed above, design voltage register value 80 may be compared to one or more predetermined design voltage range values 82, based on which design voltage value range value 82 the design voltage register value 80 falls, battery 14 is determined to have a corresponding quantity of cells.

At block 206, test module 24 reads cell voltage register values 86 from cell voltage registers 38 corresponding to each cell 38₁-38ₙ. At block 208, test module 24 identifies minimum and maximum cell voltage register values 86 read from cell voltage registers 38. At decisional block 210, a determination is made whether a maximum difference and/or spread between the minimum and maximum read cell voltage register values 86 exceeds a predetermined maximum difference threshold cell voltage value 88. If the difference between the minimum and maximum cell voltage register values 86 exceeds a predetermined maximum difference threshold cell voltage 88, the method proceeds to block 212, where test module 24 identifies battery 14 as defective. If the difference between the minimum and maximum cell voltage register values 86 does not exceed the predetermined maximum difference threshold cell voltage value 88, the method ends.

FIGURE 3 is a flow diagram illustrating another embodiment of a battery analysis method 300 in accordance with the present invention. The method begins at block 302, where test module 24 reads temperature register value 90 from temperature register 36 of battery 14. At block 304, a determination is made whether temperature register value 90 exceeds a predetermined maximum temperature threshold value 92. If temperature register value 90 exceeds a predetermined maximum temperature threshold value 92, the method proceeds to block 308, where test module 24 identifies battery 14 as defective. If temperature register value 90 does not exceed a predetermined maximum temperature threshold value 92, the method proceeds to decisional step 306, where a determination is made whether temperature register value of 90 falls below a predetermined temperature minimum threshold value 92. If temperature register value 90 falls below a predetermined minimum threshold temperature value 92, the method proceeds to block 308, where test module 24 identifies battery 14 as defective. If temperature register value 90 does not fall below a predetermined temperature minimum threshold value 92, the method ends.

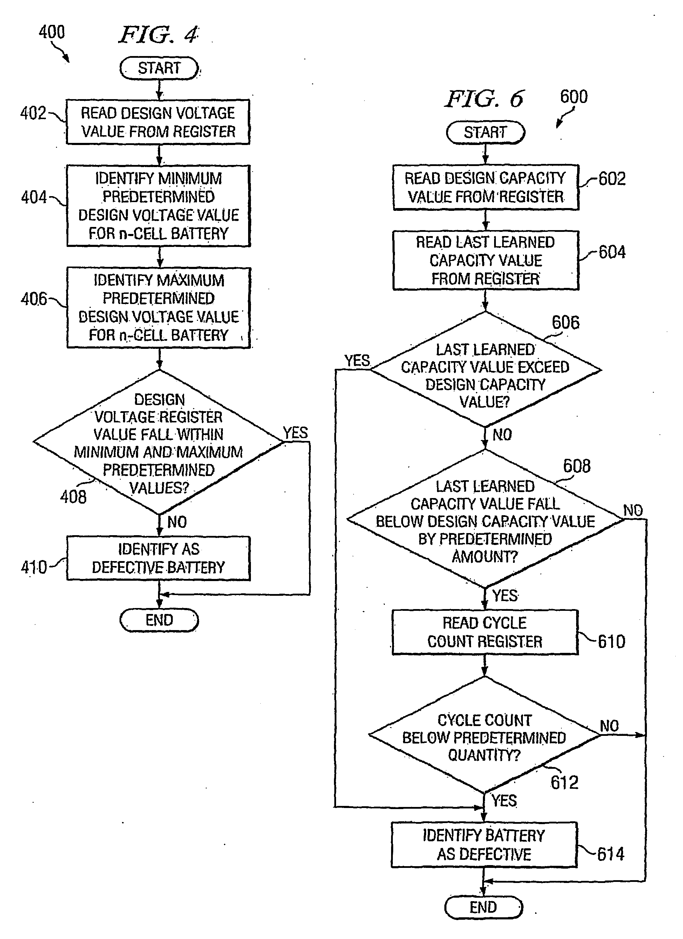

FIGURE 4 is a flow diagram illustrating another embodiment of a battery analysis method 400 in accordance with the present invention. The method begins at block 402, where test module 24 reads design voltage register value 80 from voltage register 34. At block 404, test module 24 identifies a minimum predetermined design voltage value 82 corresponding to the quantity of cells in battery 14. At block 406, test module 24 identifies a maximum predetermined design voltage value 82 corresponding to a quantity of cells in battery 14. At decisional block 408, a determination is made whether design voltage register value 80 falls within the minimum and maximum predetermined design voltage values 82. If design voltage register value 80 falls within the minimum and maximum predetermined design voltage values 82, the method ends. If the design voltage register value 80 does not fall within the predetermined minimum and maximum design voltage values 82, the method proceeds to block 410, where test module 24 identifies battery 14 as defective.

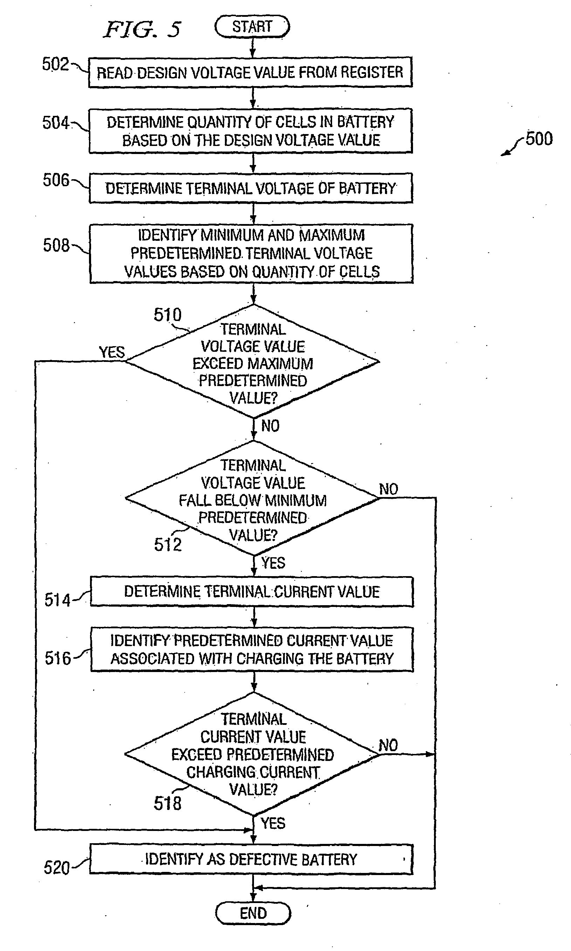

FIGURE 5 is a flow diagram illustrating another embodiment of a battery analysis method 500 in accordance with the present invention. The method begins at block 502, where a test module 24 reads design voltage register value 80 from design voltage register 34. At block 504, test module 24 determines a quantity of cells in battery 14 based on design voltage register value 80. At block 506, test module 24 determines terminal voltage value 96 associated with a voltage level at a terminal of battery 14. At block 508, test module 24 identifies minimum and maximum predetermined terminal voltage threshold values 99 based on a quantity of cells in battery 14.

At decisional block 510, a determination is made whether terminal voltage value 96 exceeds a predetermined maximum terminal voltage threshold value 99. If terminal voltage value 96 exceeds a predetermined maximum terminal voltage threshold value 99, the method proceeds to block 520, where test module 24 identifies battery 14 as defective. If terminal voltage value 96 does not exceed a maximum predetermined terminal voltage threshold value 99, the method proceeds to decisional block 512, where a determination is made whether terminal voltage value 96 falls below a predetermined minimum terminal voltage threshold value 99. If terminal voltage value 96 does not fall below a minimum predetermined terminal voltage threshold value 99, the method ends. If terminal voltage value 96 falls below a minimum predetermined terminal voltage threshold value 99, the method proceeds to block 514, where test module 24 determines terminal current value 98 associated with a current level at a terminal of battery 14. At block 516, test module 24 identifies a predetermined terminal current value 99 associated with charging battery 14. At decisional block 518, a determination is made whether terminal current value 98 exceeds the predetermined terminal charging current value 99. If the terminal current value 98 does not exceed the predetermined terminal charging current value 99, the method ends. If the terminal current value 98 exceeds the predetermined terminal charging current value 99, the method proceeds to block 520 where test module 24 identifies battery 14 as defective.

FIGURE 6 is a flow diagram illustrating another embodiment of a battery analysis method 600 in accordance with the present invention. The method begins at block 602, where test module 24 reads design capacity register value 100 from design capacity register 49. At block 604, test module 24 reads last-learned capacity register value 102 from last-learned capacity register 50. At decisional block 606, a determination is made whether last-learned capacity register value 102 exceeds design capacity register value 100. If last-learned capacity register value 102 exceeds design capacity register value 100, the method proceeds to block 614, where test module 24 identifies battery 14 as defective. If last-learned capacity register value 102 does not exceed design capacity register value 100, the method proceeds to decisional block 608, where a determination is made whether last-learned capacity register value 102 falls below a predetermined minimum design capacity value 104. If last-learned capacity register value 102 does not fall below a predetermined minimum design capacity value 104; the method ends. If last-earned capacity register value 102 falls below a predetermined minimum capacity value 104, the method proceeds to block 610, where test module 24 reads cycle count register value 110 from cycle count register 40. At decisional block 612, a determination is made whether cycle count register value 110 falls below a predetermined minimum cycle count value 112. If cycle count register value 110 does not fall below a predetermined minimum cycle count value 112, the method ends. If cycle count register value 110 falls below a predetermined minimum cycle count value 112, the method proceeds to block 614, where a test module 24 identifies battery 14 as defective.

Accordingly, embodiments of the present invention enable automatic determination of battery condition before replacement of the battery and/or return of the battery to a vendor. It should be understood that in the described methods, certain functions may be omitted, accomplished in a sequence different from that depicted in FIGURES 2-6, or performed simultaneously or in combination. Also, it should be understood that the methods depicted in FIGURES 2-6 may be altered to encompass any of the other features or aspects of the invention as described elsewhere in the specification. Further, embodiments of the present invention may be implemented in software and can be adapted to run on different platforms and operating systems. In particular, functions implemented by test module 24, for example, may be provided as an ordered listing of executable instructions that can be embodied in any computer-readable medium for use by or in connection with an instruction execution system, apparatus, or device, such as a computer-based system, processor-containing system, or other system that can fetch the instructions from the instruction execution system, apparatus, or device, and execute the instructions. In the context of this document, a "computer-readable medium" can be any means that can contain, store, communicate, propagate or transport the program for use by or in connection with the instruction execution system, apparatus, or device. The computer-readable medium can be, for example, but is not limited to, an electronic, magnetic, optical, electro-magnetic, infrared, or semi-conductor system, apparatus, device, or propagation medium.

## Claims

1. A battery analysis system (10), comprising:
a test module (24) configured to read at least one battery parameter value (80, 86, 90, 100, 102, 110, 120, 122) from at least one register (32) of a battery (14) and compare the at least one battery parameter value (80, 86, 90, 100, 102, 110, 120, 122) to a predetermined value (82, 88, 92, 104, 112. 124)
wherein the predetermined value comprises predetermined design voltage values (82) comprising a predetermined range of values associated with batteries having different cell counts;
wherein the at least one battery parameter value (80, 86, 90, 100, 102, 110, 120, 122) comprises a design voltage battery parameter value (80); and
wherein the test module (24) is configured to read the design voltage battery parameter value (80)
**characterised in that**
the test module (24) is configured to determine if the battery (14) is defective based on the comparison of the at least one battery parameter value (80, 86, 90, 100, 102, 110, 120, 122) to the predetermined value (82, 88, 92, 104, 112, 124), and the test module (24) is configured to determine a quantity of cells (38) in the battery (14) based on into which predetermined design voltage value (82) range the read design voltage battery parameter value (80) falls, and, if the read design voltage battery parameter value (80) does not fall within any predetermined design voltage value (82) range, to identify the battery (14) as being defective.

2. The system (10) of Claim 1, wherein the at least one battery parameter value (80, 86, 90, 100, 102, 110, 120, 122) comprises cell voltage battery parameter values (86) corresponding to each cell (38) of the battery (14), and wherein the test module (24) is configured to identity a maximum cell voltage value and a minimum cell voltage value from the cell voltage battery parameter values (86).

3. The system of Claim 2, wherein the test module (24) is configured to identity the battery (14) as defective if a difference between the maximum and minimum cell voltage values exceeds the predetermined value (88).

4. The system (10) of Claim 1, wherein the test module (24) is configured to evaluate the design voltage battery parameter value (80) with respect to predetermined design voltage values (82) associated with batteries having different cell counts for determining the quantity of battery cells (38).

5. The system (10) of Claim 1, wherein the test module (24) is configured to compare a terminal voltage (96) at a power supply terminal of the battery (14) with a predetermined maximum design voltage battery parameter value (82).

6. The system (10) of Claim 1, wherein the test module (24) is configured to identify the battery (14) as defective if a terminal voltage (96) at a power supply terminal of the battery (14) is below a predetermined design voltage value (82) and a terminal current value (98) at the power supply terminal of the battery (14) exceeds a predetermined charging current value 99).

7. The system (10) of Claim 1, wherein the test module (24) is configured to compare a last-learned capacity parameter value (102) with a predetermined design capacity value (104), wherein the last-learned capacity parameter value (102) indicates a battery capacity in a last charge cycle.

8. The system (10) of Claim 1, wherein the at least one battery parameter value comprises a temperature value (90).

9. The system (10) of Claim 1, wherein the at least one battery parameter value comprises a status register value (120, 122).

## Patentansprüche

1. Batterieanalysesystem (10), umfassend:
ein Testmodul (24), das derart konfiguriert ist, um wenigstens einen Batterieparameterwert (80, 86, 90, 100, 102, 110, 120, 122) von wenigstens einem Register (32) einer Batterie (14) abzulesen und den wenigstens einen Batterieparameterwert (80, 86, 90, 100, 102, 110, 120, 122) mit einem vorbestimmten Wert (82, 88, 92, 104, 112, 124) zu vergleichen,
wobei der vorbestimmte Wert vorbestimmte Design-Spannungswerte (82) umfasst, die einen vorbestimmten Bereich an Werten, die mit Batterien mit unterschiedlichen Zellzahlen assoziiert sind, umfassen;
wobei der wenigstens eine Batterieparameterwert (80, 86, 90, 100, 102, 110, 120, 122) einen Design-Spannungs-Batterieparameterwert (80) umfasst; und
wobei das Testmodul (24) derart konfiguriert ist, um den Design-Spannungs-Batterieparameterwert (80) abzulesen,
**dadurch gekennzeichnet, dass**
das Testmodul (24) derart konfiguriert ist, um basierend auf dem Vergleich des wenigstens einen Batterieparameterwerts (80, 86, 90, 100, 102, 110, 120, 122) mit dem vorbestimmten Wert (82, 88, 92, 104, 112, 124) festzustellen, ob die Batterie (14) defekt ist, und das Testmodul (24) derart konfiguriert ist, um eine Quantität an Zellen (38) in der Batterie (14) basierend darauf, in welchen vorbestimmten Bereich des Design-Spannungswerts (82) der abgelesene Design-Spannungs-Batterieparameterwert (80) fällt, zu bestimmen und, falls der abgelesene Design-Spannungs-Batterieparameterwert (80) nicht in einen beliebigen vorbestimmten Bereich des Design-Spannungswerts (82) fällt, die Batterie (14) als defekt zu identifizieren.

2. System (10) nach Anspruch 1, wobei der wenigstens eine Batterieparameterwert (80, 86, 90, 100, 102, 110, 120, 122) Zellspannungs-Batterieparameterwerte (86) entsprechend jeder Zelle (38) der Batterie (14) umfasst und wobei das Testmodul (24) derart konfiguriert ist, um einen maximalen Zellspannungswert und einen Mindest-Zellspannungswert von den Zellspannungs-Batterieparameterwerten (86) zu identifizieren.

3. System nach Anspruch 2, wobei das Testmodul (24) derart konfiguriert ist, um die Batterie (14) als defekt zu identifizieren, falls ein Unterschied zwischen dem maximalen und dem Mindest-Zellspannungswert den vorbestimmten Wert (88) übersteigt.

4. System (10) nach Anspruch 1, wobei das Testmodul (24) derart konfiguriert ist, um den Design-Spannungs-Batterieparameterwert (80) in Bezug auf die vorbestimmten Design-Spannungswerte (82), die mit den Batterien mit den verschiedenen Zellzahlen assoziiert sind, zur Bestimmung der Quantität der Batteriezellen (38) zu bewerten.

5. System (10) nach Anspruch 1, wobei das Testmodul (24) derart konfiguriert ist, um eine Klemmspannung (96) am Stromzufuhranschluss der Batterie (14) mit einem vorbestimmten maximalen Design-Spannungs-Batterieparameterwert (82) zu vergleichen.

6. System (10) nach Anspruch 1, wobei das Testmodul (24) derart konfiguriert ist, um die Batterie (14) als defekt zu identifizieren, falls eine Klemmspannung (96) an einem Stromzufuhranschluss der Batterie (14) unterhalb eines vorbestimmten Design-Spannungswert (82) liegt und ein Klemmstromwert (98) am Stromzufuhranschluss der Batterie (14) einen vorbestimmten Ladestromwert (99) übersteigt.

7. System (10) nach Anspruch 1, wobei das Testmodul (24) derart konfiguriert ist, um einen zuletzt gelernten Kapazitätsparameterwert (102) mit einem vorbestimmten Design-Kapazitätswert (104) zu vergleichen, wobei der zuletzt gelernte Kapazitäts-Parameterwert (102) auf eine Batteriekapazität in einem letzten Ladezyklus hindeutet.

8. System (10) nach Anspruch 1, wobei der wenigstens eine Batterieparameterwert einen Temperaturwert (90) umfasst.

9. System (10) nach Anspruch 1, wobei der wenigstens eine Batterieparameterwert einen Statusregisterwert (120, 122) umfasst.

## Revendications

1. Système d'analyse de batterie (10), comprenant:
un module de test (24) configuré pour lire au moins une valeur de paramètre de batterie (80, 86, 90, 100, 102, 110, 120, 122) à partir d'au moins un registre (32) d'une batterie (14) et comparer la ou les valeurs de paramètre de batterie (80, 86, 90, 100, 102, 110, 120, 122) à une valeur prédéterminée (82, 88, 92, 104, 112, 124),
la valeur prédéterminée comprenant des valeurs de tension de calcul prédéterminées (82) comprenant une plage prédéterminée de valeurs associées à des batteries ayant différents nombres d'éléments ;
la ou les valeurs de paramètre de batterie (80, 86, 90, 100, 102, 110, 120, 122) comprenant une valeur de paramètre de batterie de tension de calcul (80) ; et
le module de test (24) étant configuré pour lire la valeur de paramètre de batterie de tension de calcul (80),
**caractérisé par le fait que** le module de test (24) est configuré pour déterminer si la batterie (14) est défectueuse sur la base de la comparaison de la ou des valeurs de paramètre de batterie (80, 86, 90, 100, 102, 110, 120, 122) à la valeur prédéterminée (82, 88, 92, 104, 112, 124), et le module de test (24) est configuré pour déterminer une quantité d'éléments (38) dans la batterie (14) sur la base de la plage de valeurs de tension de calcul prédéterminées (82) dans laquelle tombe la valeur de paramètre de batterie de tension de calcul (80) lue, et, si la valeur de paramètre de batterie de tension de calcul (80) lue ne tombe dans aucune plage de valeurs de tension de calcul prédéterminées (82), identifier la batterie (14) comme étant défectueuse.

2. Système (10) selon la revendication 1, dans lequel la ou les valeurs de paramètre de batterie (80, 86, 90, 100, 102, 110, 120, 122) comprennent des valeurs de paramètre de batterie de tension d'élément (86) correspondant à chaque élément (38) de la batterie (14), et dans lequel le module de test (24) est configuré pour identifier une valeur de tension d'élément maximale et une valeur de tension d'élément minimale à partir des valeurs de paramètre de batterie de tension d'élément (86).

3. Système selon la revendication 2, dans lequel le module de test (24) est configuré pour identifier la batterie (14) comme étant défectueuse si une différence entre les valeurs de tension d'élément maximale et minimale dépasse la valeur prédéterminée (88).

4. Système (10) selon la revendication 1, dans lequel le module de test (24) est configuré pour évaluer la valeur de paramètre de batterie de tension de calcul (80) par rapport à des valeurs de tension de calcul prédéterminées (82) associées à des batteries ayant différents nombres d'éléments en vue de déterminer la quantité d'éléments de batterie (38).

5. Système (10) selon la revendication 1, dans lequel le module de test (24) est configuré pour comparer une tension de borne (96) au niveau d'une borne d'alimentation électrique de la batterie (14) avec une valeur de paramètre de batterie de tension de calcul maximale prédéterminée (82).

6. Système (10) selon la revendication 1, dans lequel le module de test (24) est configuré pour identifier la batterie (14) comme étant défectueuse si une tension de borne (96) au niveau d'une borne d'alimentation électrique de la batterie (14) est au-dessous d'une valeur de tension de calcul prédéterminée (82) et une valeur de courant de borne (98) au niveau de la borne d'alimentation électrique de la batterie (14) dépasse une valeur de courant de charge prédéterminée (99).

7. Système (10) selon la revendication 1, dans lequel le module de test (24) est configuré pour comparer une valeur de paramètre de capacité apprise en dernier (102) avec une valeur de capacité de calcul prédéterminée (104), la valeur de paramètre de capacité apprise en dernier (102) indiquant une capacité de batterie dans le dernier cycle de charge.

8. Système (10) selon la revendication 1, dans lequel la ou les valeurs de paramètre de batterie comprennent une valeur de température (90).

9. Système (10) selon la revendication 1, dans lequel la ou les valeurs de paramètre de batterie comprennent une valeur de registre d'état (120, 122).
